Europäisches Patentamt

European Patent Office

Office européen des brevets

(19)

(11) Veröffentlichungsnummer: **0 316 619 B1**

## EUROPÄISCHE PATENTSCHRIFT

(12)

(45) Veröffentlichungstag der Patentschrift: **29.12.93**

(51) Int. Cl.5: **G01R 15/07**, G01R 29/12, G02F 1/01

(21) Anmeldenummer: **88117700.0**

(22) Anmeldetag: **25.10.88**

(54) **Faseroptischer Sensor.**

(30) Priorität: **05.11.87 CH 4322/87**
**02.05.88 CH 1628/88**

(43) Veröffentlichungstag der Anmeldung:
**24.05.89 Patentblatt 89/21**

(45) Bekanntmachung des Hinweises auf die
Patenterteilung:
**29.12.93 Patentblatt 93/52**

(84) Benannte Vertragsstaaten:
**CH DE FR GB IT LI SE**

(56) Entgegenhaltungen:
**US-A- 4 477 723**
**US-A- 4 524 322**

**IEEE JOURNAL OF OUANTUM ELECTRONICS,
Band OE-18, Nr. 4, April 1982, Seiten 670-675,
US; K.P. KOO et al.: "An electric field sensor
utilizing a piezoelelctric polyvinylidene fluoride (PVF2) film in a single-mode fiber interferometer"**

**PROCEEDINGS SPIE INT. SOC. OPT.
ENG.(USA), Band 425, 23.-24. August 1983,
Seiten 111-113, San Diego, US; R.P. DePAULA
et al.: "Acousto-optic all-fiber modulator"**

(73) Patentinhaber: **ASEA BROWN BOVERI AG**

**CH-5401 Baden(CH)**

(72) Erfinder: **Bohnert, Klaus, Dr.**
**Loonstrasse 9**
**CH-5443 Niederrohrdorf(CH)**
Erfinder: **Kaufmann, Meinolph**
**Im Tobelacher 2**
**CH-5405 Baden(CH)**
Erfinder: **Nehring, Jürgen, Dr.**
**Neustrasse 42**
**CH-5430 Wettingen(CH)**

EP 0 316 619 B1

## Beschreibung

Technisches Gebiet

Die Erfindung betrifft einen faseroptischen Sensor zum Messen einer vorbestimmten Richtungskomponente eines elektrischen Feldes gemäss dem Oberbegriff des ersten Anspruchs.

Stand der Technik

Zum Messen von elektrischen Feldstärken bieten sich elektrooptische Effekte wie der Pockels-Effekt oder der Kerr-Effekt an. Dabei kann von der Tatsache Gebrauch gemacht werden, dass sich bei gewissen Materialien der Brechungsindex linear (Pockels-Effekt) resp. quadratisch (Kerr-Effekt) mit einer angelegten Feldstärke ändert. Besitzen diese Materialien ausserdem bestimmte Symmetrieeigenschaften, so kann auch eine vorbestimmte Richtungskomponente eines elektrischen Feldes gemessen werden. Während sogenannte Pockelssensoren teuere, einkristalline Materialien hoher optischer Qualität erfordern, welche vielfach empfindlich auf Umgebungseinflüsse (z.B. Feuchtigkeit) reagieren, sind sogenannte Kerrsensoren wegen ihrer geringen Empfindlichkeit vorwiegend für grosse Feldstärken geeignet. Diese Nachteile können umgangen werden, wenn die elektrische Feldstärke mittels des inversen Piezoeffektes gemessen wird. Dazu wird eine Dimensionsänderung eines piezoelektrischen Körpers im elektrischen Feld auf eine Aenderung der Länge einer Glasfaser übertragen, welche auf interferometrische Weise gemessen werden kann.

In diesem Zusammenhang wird auf die Veröffentlichung "Fiber-optic-Fabry-Perot Interferometer and its Sensor Application", T. Yoshino et al. IEEE J. of Quant. Electr. QU-18 1624 (1982), verwiesen. Darin wird vorgeschlagen, um eine Scheibe aus einem piezoelektrischem Keramik, kurz PZT genannt, ein faseroptisches Fabry-Perot-Interferometer zu wickeln und an die Scheibe eine Wechselspannung anzulegen. Die periodische Dimensionsänderung des PZT führt zu periodischen Intensitätsschwankungen des im faseroptischen Fabry-Perot-Interferometer eingekoppelten Lichtes.

Eine andere Druckschrift, "Electric Field Sensitive Optical Fibre Using Piezoelektric Polymer Coating", L.J. Donalds et al. Electr. Lett 18, 327 (1982), offenbart eine Messanordnung, bei welcher eine von einem piezoelektrischen Polymer ummantelte Glasfaser und ein Mach-Zehnder-Interferometer angewendet werden, um eine elektrische Feldstärke zu bestimmen.

Die US 4,477,723 offenbart ein piezoelektrisches Messgerät zur Messung eines elektrischen Feldes. Der Sensor des Messgeräts besteht aus einem piezoelektrischen Plättchen, auf welches eine Glasfaser starr angebracht wird. Vorzugsweise wird als piezoelektrisches Material elektrisch gepoltes, kristallines PVDF verwendet. Die Polung erfolgt rechtwinklig zur Längsrichtung der Faser. Mit einem solchen Sensor kann mittels eines Mach-Zehnder-Interferometers ein elektrisches Feld gemessen werden.

Alle bekannten, piezoelektrischen Sensoren, inklusive desjenigen der US 4,477,723, messen den Betrag der Feldstärke, wenn die Richtung des elektrischen Feldes bekannt ist. Sie können jedoch nicht verwendet werden, wenn sowohl Betrag als auch Richtung des elektrischen Feldes bestimmt werden sollen.

## Darstellung der Erfindung

Aufgabe der Erfindung ist es, einen faseroptischen Sensor zum Messen einer vorbestimmten Richtungskomponente eines elektrischen Feldes der eingangs genannten Art anzugeben, welcher Sensor nur genau diejenige Richtungskomponente des elektrischen Feldes misst, welche in einer durch den Sensor frei vorgegebbaren Richtung liegt.

Diese Aufgabe wird bei einem Sensor der eingangs genannten Art durch die Merkmale der unabhängigen Ansprüche 1, 3 und 4 gelöst.

Der Kern der Erfindung ist es also, die Form des piezoelektrischen Körpers, Art und Weise wie die Glasfaser am piezoelektrischen Körper befestigt ist, Kristallklasse und kristallographische Orientierung des Materiales des piezoelektrischen Körpers so aufeinander abzustimmen, dass nur eine Komponente des elektrischen Feldes detektiert wird, der Sensor gegenüber allen anderen Komponenten aber unempfindlich ist.

Zu diesem Zweck wird für die in Frage kommenden Kristallklassen in Tabellen angegeben, wie die kristallographische Orientierung bezüglich der vorbestimmten Richtungskomponente bzw. der gegebene Längenabschnitt der Glasfaser in Bezug auf die kristallographische Orientierung nach den erfindungsgemässen Tabellen gewählt werden muss.

Weitere Ausführungsformen ergeben sich aus den abhängigen Ansprüchen.

2

EP 0 316 619 B1

Kurze Beschreibung der Zeichnung

Nachfolgend soll die Erfindung anhand von Ausführungsbeispielen im Zusammenhang mit der Zeichnung näher erläutert werden.

Es zeigen:

Fig. 1    erfindungsgemässe Anordnung zum Messen einer Richtungskomponente eines elektrischen Feldes;

Fig. 2    faseroptischer Sensor mit einem piezoelektrischen Körper in der Form einer Scheibe;

Fig. 3    Darstellung der Funktionsweise des faseroptischen Sensors gemäss Fig. 2;

Fig. 4    faseroptischer Sensor mit einem piezoelektrischen Körper in Form einer Platte;

Fig. 5    faseroptischer Sensor mit einem piezoelektrischen Körper in Form eines Hohlzylinders; und

Fig. 6a-e    faseroptische Sensoren mit einem piezoelektrischen Körper in Form einer Platte, bei welchen eine Körperachse parallel zu einer Plattennormalen steht; und

Fig. 7    faseroptischer Sensor mit einem piezoelektrischen Körper in Form einer Platte, bei welchen eine Körperachse senkrecht zur Plattennormalen steht.

Wege zur Ausführung der Erfindung

In einem ersten Ausführungsbeispiel wird ein faseroptischer Sensor mit einem piezoelektrischen Körper in Form einer Scheibe beschrieben.

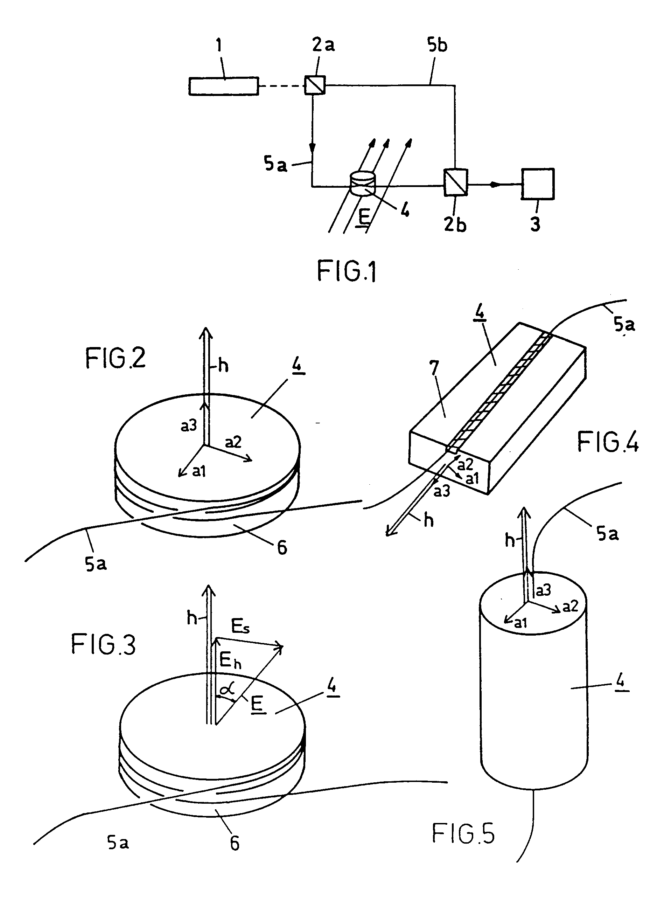

Fig. 1 zeigt eine erfindungsgemässe Anordnung zum Messen einer Richtungskomponente eines elektrischen Feldes. Ein Laser 1 liefert kohärentes Licht. Dieses wird in einer für ein Mach-Zehnder-Interferometer typischen Weise mit einem ersten Strahlteiler 2a in zwei Teilwellen aufgeteilt. Eine erste Teilwelle wird in eine polarisationserhaltende erste Glasfaser 5a und eine zweite Teilwelle in eine zweite Glasfaser 5b eingekoppelt. Die erste Glasfaser 5a dient als faseroptischer Sensor. Sie ist in einem gegebenen Längenabschnitt mit einem piezoelektrischen Körper 4 starr verbunden. Die zweite Glasfaser 5b dient als Referenzpfad. In einem Strahlteiler 2b werden die beiden Teilwellen kohärent überlagert und einem Detektor 3 zugeführt.

Wenn z.B. ein elektrisches Wechselfeld E auf den piezoelektrischen Körper 4 einwirkt, so wird dadurch auf Grund des inversen piezoelektrischen Effektes eine periodische Aenderung einer Länge der Glasfaser 5a bewirkt. Die Aenderung der Länge wiederum erzeugt eine Phasenschiebung der in der Glasfaser 5a laufenden Teilwelle. Als Folge davon ändert sich die Intensität des aus dem Strahlteiler 2b austretenden Lichtes, welche schliesslich im Detektor 3 gemessen wird. Da bei gegebener Richtung des elektrischen Feldes die Phasenschiebung direkt proportional zur Feldstärke ist, kann aus der gemessenen Intensität ohne weiteres auf die Feldstärke geschlossen werden.

Fig. 2 zeigt den eigentlichen faseroptischen Sensor. Der piezoelektrischen Körper 4 hat die Form einer Scheibe. Die Glasfaser 5a ist mit dem gegebenen Längenabschnitt unter einer mechanischen Vorspannung an einem Scheibenrand 6 befestigt. Bevorzugterweise wird die Glasfaser 5a mehrmals (in diesem Beispiel zweimal) um die Scheibe gewickelt. Auf diese Weise vervielfacht sich die Wirkung einer Umfangsänderung der Scheibe auf die Phasenschiebung.

Der Kern der Erfindung besteht darin, die Form des piezoelektrischen Körpers, die Art und Weise wie die Glasfaser 5a am piezoelektrischen Körper 4 befestigt ist und eine Kristallklasse und eine kristallographische Orientierung des Materials, aus welchem der piezoelektrischen Körper besteht, so aufeinander abzustimmen, dass der piezoelektrischen Körper genau eine Körperachse besitzt, die sich dadurch auszeichnet, dass nur eine Richtungskomponente des elektrischen Feldes mittels des inversen piezoelektrischen Effektes auf die Glasfaser 5a wirken kann, welche parallel zu dieser Körperachse liegt. Richtungskomponenten des elektrischen Feldes, die senkrecht zu dieser Körperachse stehen, können die Länge der Glasfaser 5a nicht ändern.

Einem Kristall lässt sich auf bekannte Art ein orthogonales Koordinatensystem zuordnen, mit welchem sich eine Orientierung des Kristalls beschreiben lässt. In Fig. 2 wird die gewählte Orientierung des Kristalls durch drei orthogonale Achsen a1, a2, a3 angegeben. Die Achse a3 ist parallel zu einer Scheibennormalen. Die beiden Achsen a1, a2 liegen damit in einer Ebene, welche parallel zu einer Hauptfläche der Scheibe ist. Ihre Orientierung in dieser Ebene ist beliebig. Die Körperachse h ist hier parallel zur Scheibennormalen.

Tabelle I gibt an, welche Kristallklassen für einen piezoelektrischen Körper in der Form einer Scheibe geeignet sind und wie die kristallographische Orientierung jeweils gewählt werden soll. Zur Bezeichnung der Kristallklassen ist die Schoenflies resp. die internationale Notation verwendet worden. Zu jeder Kristallklasse ist angegeben, welche kristallographische Achse (X-Achse/Y-Achse/Z-Achse) die Achse a3 darstellt. Die Bezeichnung der kristallographischen Achsen entspricht der Konvention, wie sie im Buch "Physical

3

Properties of Crystals" J.F. Nye, Oxford University Press, 1967, zugrunde gelegt wird.

**Tabelle I**

| Kristallklasse (Schoenflies [international]) | Drehzahl der Achse a3 | Achse a3 entspricht kristallographischer |
|---|---|---|
| C2v  [2mm] | 2 | |
| C4v  [4mm] | 4 | |
| C4   [4] | 4 | |
| C3   [3] | 3 | |
| C3v  [3m] | 3 | Z-Achse |
| C6   [6] | 6 | |
| C6v  [6mm] | 6 | |
| C∞   [∞] | ∞ | |
| C∞v  [∞mm] | ∞ | |
| C2   [2] | 2 | |
| D3h  [62m] | 2 | Y-Achse |
| D3   [32] | 2 | X-Achse |

Fig. 3 zeigt eine Darstellung der Funktionsweise des faseroptischen Sensors. Ein elektrisches Feld mit einem Feldvektor E, wirke am Ort des faseroptischen Sensors in der eingezeichneten Richtung und schliesse mit der Körperachse h einen Winkel $\alpha$ ein. Der Feldvektor E lässt sich in eine zur Körperachse h parallele Richtungskomponente Eh und eine dazu senkrechte Richtungskomponente Es zerlegen. Der faseroptische Sensor "sieht" jedoch nur die Richtungskomponente Eh, da nur sie mittels des inversen piezoelektrischen Effekts zu einer Umfangsänderung der Scheibe führt. Die Orientierung der Körperachse h, d.h. der Scheibennormale, bestimmt somit, welche Richtungskomponente des elektrischen Feldes gemessen wird.

Bevorzugterweise besteht der piezoelektrische Körper 4 aus elektrisch gepoltem und mechanisch gerecktem PVDF (Polyvinylidenfluorid, Kristallklasse C2v), aus $\alpha$-Quarz (Kristallklasse D3) aus einer piezoelektrischen Keramik (PZT, Kristallklasse C∞v) der aus Lithiumniobat (LiNb0$_3$, Kristallklasse C3v). Bei einem geeigneten Ausführungsbeispiel hat die Scheibe einen Durchmesser von etwa 10 mm und eine Dicke von 1-3 mm. Besteht der piezoelektrischen Körper z.B. aus PVDF und ist das PVDF in der krystallographischen Y-Achse gereckt und in der kristallographischen Z-Achse gepolt, so bewirkt ein elektrisches Feld von 1 V/cm eine Umfangsänderung von ca. 0.03 Å. Wird die Glasfaser 10mal um die Scheibe herumgewickelt, so führt das zu einer Phasenschiebung von etwa $4 \cdot 10^{-4}$ rad bei einer Wellenlänge von 630 nm.

Im folgenden werden weitere bevorzugte Ausführungsformen des faseroptischen Sensors beschrieben. In einem zweiten Ausführungsbeispiel wird ein faseroptischer Sensor mit einem piezoelektrischen Körper 4 in der Form einer Platte vorgestellt. Es wird eine zur Glasfaser 5a parallele Richtungskomponente des elektrischen Feldes gemessen.

Fig. 4 zeigt einen entsprechenden faseroptischen Sensor. Der piezoelektrische Körper 4 hat die Form einer länglichen Platte. Die Glasfaser 5a ist in einer Längsrichtung auf einer geraden Linie auf einer Hauptfläche 7 der Platte befestigt. Zum Befestigen der Glasfaser 5a kann die Platte beispielsweise mit einer geraden Nut versehen sein, in welche die Glasfaser 5a eingelegt und mit einem Kleber vergossen wird. Eine kristallographische Orientierung ist wiederum durch die drei Achsen a1, a2, a3 dargestellt. Die Körperachse h liegt in Richtung der geraden Linie, auf welcher der gegebene Längenabschnitt der Glasfaser 5a mit der Platte verbunden ist, d.h. parallel zur Glasfaser 5a, in diesem Fall in Längsrichtung der Platte.

Wie die kristallographische Orientierung des piezoelektrischen Körpers 4 für verschiedene Kristallklassen gewählt werden soll, geht ebenfalls aus Tabelle I hervor. Die beiden Achsen a1 und a2 stehen senkrecht zur Körperachse h, haben aber sonst eine beliebige Orientierung. Daraus ergibt sich, dass der

4

piezoelektrische Körper auch eine andere, längliche Form haben kann, solange nur die oben genannten Bedingungen (Tabelle I) erfüllt sind.

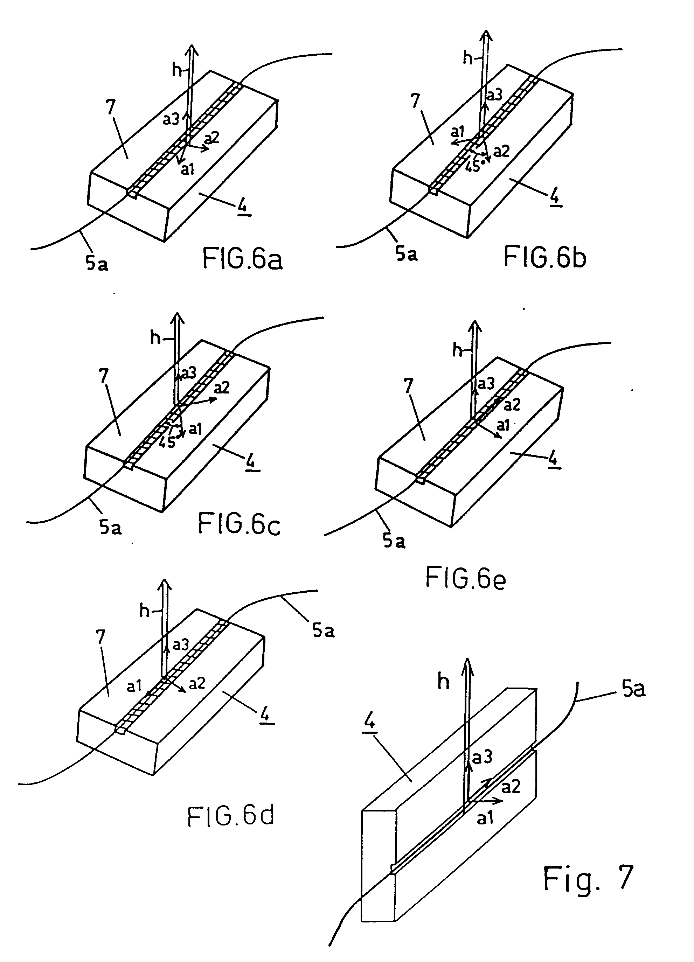

Fig. 5 zeigt eine zu Fig. 4 äquivalente Ausführungsform, bei welcher der piezoelektrische Körper 4 als Hohlzylinder gestaltet ist. Die Glasfaser 5a ist im Hohlzylinder z.B. mit einem Kleber fixiert.

In einem dritten Ausführungsbeispiel wird ein faseroptischer Sensor beschrieben, bei welchem der piezoelektrische Körper 4 ebenfalls die Form einer Platte hat, bei welchem jedoch eine Richtungskomponente des elektrischen Feldes parallel zu einer Plattennormalen gemessen wird.

Fig. 6a-c zeigen drei weitere Ausführungsbeispiele derartiger faseroptischer Sensoren. Aeusserlich unterscheiden sie sich nicht von der in der Fig. 4 gezeigten. Deshalb sind gleiche Teile mit gleichen Bezugszeichen versehen. Sie unterscheiden sich jeweils durch die kristallographische Orientierung, dargestellt durch drei paarweise orthogonale Achsen a1, a2, a3. Die Körperachse h ist wie bereits gesagt stets senkrecht zu einer Hauptfläche der Platte, d.h. parallel zu einer Plattennormalen.

In Fig. 6a ist die Achse a3 eine kristallographische Z-Achse oder Y-Achse (je nach Kristallklasse). Die beiden anderen Achsen a1, a2 liegen in einer Ebene parallel zur Hauptfläche der Platte. Ihre Orientierung ist beliebig. In Tabelle II sind die Kristallklassen aufgeführt, für welche die soeben beschriebene Ausführungsform geeignet ist. Man beachte, dass die Kristallklasse C2 die einzige ist, bei welcher die Achse a3 der kristallographischen Y-Achse entspricht.

## Tabelle II

| Kristallklasse (Schoenflies [international]) | Drehzahl der Achse a3 | Achse a3 entspricht kristallographischer |
|---|---|---|
| C2v [2mm] | 2 | |
| C4v [4mm] | 4 | |
| C4 [4] | 4 | |
| C6 [6] | 6 | Z-Achse |
| C6v [6mm] | 6 | |
| C∞ [∞] | ∞ | |
| C∞v [∞mm] | ∞ | |
| C2 [2] | 2 | Y-Achse |

In den bisherigen Ausführungsbeispielen war jeweils nur eine kristallographische Achse in ihrer Richtung bestimmt. Bei den nun folgenden sind jeweils zwei Achsenrichtungen vorgegeben, nämliche eine zur Körperachse h parallele kristallographische Achse und eine in Bezug auf die Glasfaser 5a in genau bestimmter Richtung liegende zweite kristallographische Achse.

Fig. 6b und c zeigen die für die Kristallklasse D2, D2d, T, Td, D4, D6 (Schoenflies-Notation) geeigneten Ausführungsformen. Bei diesen Kristallklassen ist es erforderlich, dass die Richtung der Glasfaser 5a in Richtung einer Winkelhalbierenden der beiden Achsen a1 und a2 liegt. Tabelle III enthält die für die genannten Kristallklassen geeigneten kristallographischen Orientierungen.

## Tabelle III

| Kristallklasse (Schoenflies [international]) | | Achse a3 entspricht kristallographischer | Glasfaser in Richtung |
|---|---|---|---|
| S4 | [4] | Z-Achse | krist. X-Achse |
| | | | krist. Y-Achse |
| D3 | [32] | | |
| D3h | [62m] | X-Achse | krist. Y-Achse |
| D2 | [222] | X-Achse | Wyz oder W-yz |
| D2d | [42m] | | |
| T | [23] | Y-Achse | Wzx oder W-zx |
| Td | [43m] | Z-Achse | Wxy oder W-xy |
| D4 | [422] | X-Achse | Wyz oder W-yz |
| D6 | [622] | Y-Achse | Wzx oder W-zx |

Für alle vier Kristallklassen D2, D2d, T, Td kann die Achse a3 entweder einer kristallographischen X-Achse, einer kristallographischen Y-Achse oder einer kristallographischen Z-Achse entsprechen. Ist z.B. die Achse a3 die kristallographische X-Achse, so muss die Glasfaser in Richtung einer Winkelhalbierenden Wyz, W-yz von der kristallographischen X- und Y-Achse liegen. Die Winkelhalbierende Wyz bezeichnet die Winkelhalbierende, welche zwischen positiver Y-Achse und positiver Z-Achse liegt und die Winkelhalbierende W-yz diejenige, welche zwischen der negativen Y-Achse und der positiven Z-Achse liegt. Die beiden Winkelhalbierenden Wyz und W-yz stehen senkrecht zueinander. In analoger Weise sind die Winkelhalbierenden Wzx, W-zx, Wxy, W-xy zu verstehen.

Die beiden Kristallklassen D4, D6 unterscheiden sich von den Kristallklassen D2, D2d, T, Td dadurch, dass die dritte Variante, nämlich dass die kristallographische Z-Achse der Achse a3 entspricht und die Glasfaser in Richtung einer Winkelhalbierenden Wxy, W-xy liegt, nicht existiert.

In Fig. 6d ist die für die Kristallklassen D3, D3h geeignete kristallographische Orientierung dargestellt. Die Achse a1 ist in diesem Fall parallel zur Glasfaser 5a. Die Achse a3 ist die kristallographische X-Achse und die Achse a1 die kristallographische Y-Achse (siehe Tabelle III).

In Fig. 6e ist schliesslich die für die Kristallklasse S4 geeigneten kristallographischen Orientierungen dargestellt. Die Achse a3 ist die kristallographische Z-Achse. Die Glasfaser ist entweder in Richtung der kristallographische X-Achse (Fig. 6d) oder in Richtung der kristallographischen Y-Achse (Fig. 6e).

Weitere Untersuchungen haben gezeigt, dass sich für die zweite Ausführungsform, bei welcher eine zur Glasfaser 5a parallele Richtungskomponente des elektrischen Feldes gemessen wird (Fig. 4 und Fig. 5), auch die beiden Kristallklassen T und Td eignen.

Zur Verdeutlichung dieser Tatsache soll die oben gezeigte Tabelle I durch zwei neue Tabellen IV und V ersetzt werden.

Darstellungsmässig unterscheiden sich die folgenden neuen Tabellen von den alten Tabellen dadurch, dass nicht mehr auf ein dem Kristall zugrunde gelegtes Koordinatensystem (mit kristallographischer X-, Y- und Z-Achse) sondern soweit als möglich direkt auf die Symmetrieachsen (Drehachsen) Bezug genommen wird.

Die nachfolgende Tabelle IV stimmt inhaltlich mit Tabelle I vollständig überein. Sie gibt an, welche Kristallklassen für einen piezoelektrischen Körper (4) in der Form einer Scheibe geeignet sind und wie die kristallographische Orientierung in bezug auf die Scheibennormale gewählt werden soll.

```
Tabelle IV

Kristallklassen                       Drehachse parallel
(Schoenflies [international])         zur Scheibennormalen
------------------------------------------------------------------

C2    [2]                             2-zählige Achse
C2v   [2mm]                           2-zählige Achse
C3    [3]                             3-zählige Achse
C3v   [3m]                            3-zählige Achse
D3    [32]                            2-zählige Achse
D3h   [62m]                           2-zählige Achse
C4    [4]                             4-zählige Achse
C6    [6]                             6-zählige Achse
C∞    [∞]                             ∞-zählige Achse
C4v   [4mm]                           4-zählige Achse
C6v   [6mm]                           6-zählige Achse
C∞v   [∞mm]                           ∞-zählige Achse
```

Die Tabelle V entspricht der um die beiden Kristallklassen T, Td erweiterten Tabelle I. Sie gibt an, welche Kristallklassen für die Ausführungsformen geeignet sind, bei welchen eine Komponente des elektrischen Feldes gemessen wird, welche parallel zur Glasfaser resp. in Längsrichtung der Platte liegt (Fig. 4, Fig. 5). Festgelegt wird nur die Orientierung der zur Glasfaser parallel liegenden Drehachse, die Orientierung der übrigen Drehachsen ist beliebig.

```
Tabelle V

Kristallklassen                       Drehachse parallel
(Schoenflies [international])         zur Glasfaser
------------------------------------------------------------------

C2    [2]                             2-zählige Achse
C2v   [2mm]                           2-zählige Achse
C3    [3]                             3-zählige Achse
C3v   [3m]                            3-zählige Achse
D3    [32]                            2-zählige Achse
D3h   [62m]                           2-zählige Achse
C4    [4]                             4-zählige Achse
C6    [6]                             6-zählige Achse
C∞    [∞]                             ∞-zählige Achse
C4v   [4mm]                           4-zählige Achse
C6v   [6mm]                           6-zählige Achse
C∞v   [∞mm]                           ∞-zählige Achse
T     [23]                            3-zählige Achse
Td    [43m]                           3-zählige Achse
```

Am Beispiel eines scheibenförmigen Sensors (Fig. 2) mit einem piezoelektrischen Körper der Kristallklasse D3 (z.B. Quarz) soll die Erfindung nochmals erläutert werden.

Die Matrix der piezoelektrischen Dehnungskoeffizienten ist in diesem Fall bekanntlich (siehe z.B. J.F. Nye)

| d11 | -d11 | 0 | d14 | 0 | 0 |
| 0 | 0 | 0 | 0 | -d14 | -2d11 |
| 0 | 0 | 0 | 0 | 0 | 0 |

Ein in Richtung einer kristallographischen X-Achse (2-zählige Achse) liegendes elektrisches Feld erzeugt also eine longitudinale Dehnung in Richtung der X-Achse, eine transversale Dehnung in Richtung der Y-Achse und eine (longitudinale) Scherung um die X-Achse (d.h. eine Scherung in einer Y-Z-Ebene).

Ein elektrisches Feld in Richtung der kristallographischen Y-Achse bewirkt eine Scherung um die Y-Achse und eine um die Z-Achse.

Ein elektrisches Feld in Richtung der kristallographischen Z-Achse (3-zählige Achse) schliesslich erzeugt überhaupt keine Dehnung.

Um nun ausschliesslich die Richtungskomponente parallel zur Scheibennormalen zu detektieren, muss eine kristallographische X-Achse parallel zur Scheibennormalen liegen. Die transversale Dehung - bewirkt durch einen zur Scheibennormalen parallel liegenden Anteil des auftretenden elektrischen Feldes - ist dann der einzig mögliche Einfluss des Feldes auf eine Aenderung des Umfangs der Scheibe und damit auf eine Aenderung der Länge der Glasfaser. Scherungen, welche ein Feld entlang der Y-Achse erzeugt, haben keinen Einfluss auf den Umfang der Scheibe.

Für die relative Aenderung des Umfanges ergibt sich somit

$$\frac{L}{L} = -\frac{1}{2} \, d11 \, E(x,in)$$

wobei $E(x,in)$ den Anteil des elektrischen Feldes bezeichnet, welcher im piezoelektrischen Körper in Richtung zur Scheibennormalen liegt, welche identisch mit einer 2-zähligen Drehachse ist. Der Faktor 1/2 folgt aus der Tatsache, dass die entsprechende Dehnung nicht radial sondern nur entlang der Y-Achse wirkt.

Auf analoge Weise lässt sich auch die Wirkungsweise aller übrigen Ausführungsformen veranschaulichen.

Die Ausführungsformen, welche durch die beiden Tabellen II und III beschrieben werden, sind der Klarheit der Darstellung halber in den nachfolgenden Tabellen VIa und VIb zusammengefasst worden, welche noch durch die Kristallklasse D∞ vervollständigt worden sind. Die Tabellen VIa und VIb geben an, welche Kristallklassen für die Ausführungsformen geeignet sind, bei welchen der piezoelektrische Körper die Form einer Platte hat und eine senkrecht zur Glasfaser liegende Richtungskomponente des elektrischen Feldes gemessen wird (Fig. 6a-e). Festgelegt wird eine zur vorbestimmten Richtungskomponente parallel (‖) resp. senkrecht (⊥) liegende Drehachse und die Richtung der Glasfaser in Bezug auf die kristallographische Orientierung. Da im allgemeinen für die Glasfaser mehrere Richtungen möglich sind, wobei die relative Aenderung der Länge der Glasfaser von ihrer Richtung abhängt, wird gegebenenfalls zusätzlich diejenige Richtung angegeben, in welcher die Aenderung der Länge verschwindet. In diese Richtung darf die Glasfaser also nicht orientiert sein. Entsprechend gibt es eine Richtung, in welcher die Glasfaser eine maximale Dehnung erfährt. In jedem Fall ist der gegebnee Längenabschnitt der Glasfaser aber senkrecht zur vorbestimmten Richtungskomponente.

Tabelle VIa

| Kristallklasse (Schoenflies [international]) | | Drehachse ∥ resp. ⊥ zur vorbestimmten Richtungskomponente | unzulässige Orientierung der Glasfaser |
|---|---|---|---|
| C2 | [2] | ∥ 2-zählige Achse | $d23 \cos^2\alpha + d21 \sin^2\alpha + d25 \sin2\alpha = 0$ *) |
| C2v | [2 mm] | ∥ 2-zählige Achse | $\tan\alpha = \sqrt{-d32/d31}$ **) |
| S4 | [4̄] | ⊥ und ∥ 4̄-zählige Achse | $\tan 2\alpha = -d31/d36$ **) |
| C4 | [4] | ∥ 4-zählige Achse | |
| C6 | [6] | ∥ 6-zählige Achse | |
| C∞ | [∞] | ∥ ∞-zählige Achse | |
| C4v | [4 mm] | ∥ 4-zählige Achse | |
| C6v | [6 mm] | ∥ 6-zählige Achse | |
| C∞v | [∞ mm] | ∥ ∞-zählige Achse | |
| D3 | [32] | ∥ 2-zählige Achse | ∥ 3-zählige Achse ***) und $\tan\alpha = 2d14/d11$ |
| D3h | [6̄2 m] | ∥ 2-zählige Achse | ∥ 3-zählige Achse |
| D2 | [222] | ∥ 2-zählige Achse | } ∥ 2-zählige Achse |
| D2d | [4̄2 m] | ∥ 2-zählige Achse | |
| T | [23] | ∥ 2-zählige Achse | ∥ 2-zählige Achse |
| Td | [4̄3 m] | ∥ 4̄-zählige Achse | ∥ 4̄-zählige Achse |
| D4 | [422] | ⊥ 4-zählige Achse | ∥ und ⊥ 4-zählige Achse |
| D6 | [622] | ⊥ 6-zählige Achse | ∥ und ⊥ 6-zählige Achse |
| D∞ | [∞22] | ⊥ ∞-zählige Achse | ∥ und ⊥ ∞-zählige Achse |

*) $\alpha$ = Winkel zwischen Z-Achse und Glasfaser

**) $\alpha$ = Winkel zwischen X-Achse und Glasfaser

***) $\alpha$ = Winkel zwischen 3-zähliger Achse und Glasfaser

dij = piezoelektrische Dehnungskoeffizienten

Der Winkel $\alpha$ ist positiv, wenn die Achse gegenüber der Glasfaser im Gegenuhrzeigersinn gedreht wird.

Tabelle VIb

| Kristallklasse (Schoenflies [international]) | | Drehachse resp. zur vorbestimmten Richtungskomponente | Richtung der Glasfaser für max. Dehnung |
|---|---|---|---|
| C2 | [2] | ∥ 2-zählige Achse | } |
| C2v | [2 mm] | ∥ 2-zählige Achse | } abhängig vom Verhältnis |
| S4 | [$\bar{4}$] | ∥ $\bar{4}$-zählige Achse | } der Dehnungskoeffizienten |
| C4 | [4] | ∥ 4-zählige Achse | } |
| C6 | [6] | ∥ 6-zählige Achse | } |
| C∞ | [∞] | ∥ ∞-zählige Achse | } |
| C4v | [4 mm] | ∥ 4-zählige Achse | } beliebig |
| C6v | [6 mm] | ∥ 6-zählige Achse | } |
| C∞v | [∞ mm] | ∥ ∞-zählige Achse | } |
| D3 | [32] | ∥ 2-zählige Achse | abhängig von d14/d11 |
| D3h | [$\bar{6}$2 m] | ∥ 2-zählige Achse | ⊥ 3-zählige Achse |
| D2 | [222] | ∥ 2-zählige Achse | } |
| D2d | [$\bar{4}$2 m] | ∥ 2-zählige Achse | } 45° bezügl. 2-zählige Achse |
| T | [23] | ∥ 2-zählige Achse | 45° bezügl. 2-zählige Achse |
| Td | [$\bar{4}$3 m] | ∥ $\bar{4}$-zählige Achse | 45° bezügl. $\bar{4}$-zählige Achse |
| D4 | [422] | ⊥ 4-zählige Achse | 45° bezügl. 4-zählige Achse |
| D6 | [622] | ⊥ 6-zählige Achse | 45° bezügl. 6-zählige Achse |
| D∞ | [∞22] | ⊥ ∞-zählige Achse | 45° bezügl. ∞-zählige Achse |

Für die Kristallklassen C2v gibt es nicht in jedem Fall eine unzulässige Orientierung der Glasfaser. Falls nämlich d23 und d21, resp. d32 und d31 gleiche Vorzeichen haben, ist das Verhältnis unter der Wurzel negativ. Das bedeutet, dass es keinen unzulässigen Winkel $\alpha$ gibt.

Es ist zu beachten, dass sich für S4 zwei senkrecht zueinander liegende unzulässige Richtungen ergeben.

Schliesslich sei noch darauf hingewiesen, dass bei den Kristallklassen C4,C6,C∞,C4v,C6v,C∞v die Orientierung der Glasfaser beliebig its, solange sie natürlich senkrecht zur vorbestimmten Richtungskomponente liegt.

Für die Praxis ergeben sich aus Tabellen VIa und VIb zwei Gruppen von besonders vorteilhaften Ausführungsformen. In der einen wird die Plattennormale jeweils parallel zur vorbestimmten Richtungskomponente gewählt (Fig. 6a-e) und in der anderen wird sie senkrecht dazu gewählt.

Fig. 7 veranschaulicht das Prinzip der zuletzt genannten Anordnung. Fig. 7 geht z.B. so aus Fig. 6e hervor, dass man die Platte von Fig. 6e immer schmaler und gleichzeitig immer dicker macht. Aufgrund dieses Gedankenexperiments wird klar, dass für alle Ausführungsformen gemäss Fig. 6a-e (Plattennormale parallel zur vorgebenen Richtungskomponente) eine entsprechende gemäss Flg. 7 (Plattennormale senkrecht zur vorgebenen Richtungskomponente) existiert.

Zu den handelsüblichen piezoelektrischen Materialien, welche für die Erfindung geeignet sind, gehören $\alpha$-Quarz (D3), Lithiumniobat (C3v), Bariumtitanat (C4v), GaAs (Td) und piezoelektrische Keramiken (PZT, C6v) ebenso wie piezoelektrische Polymere PVDF und verwandte Stoffe (C2v).

Für eine hohe Empfindlichkeit des Sensors sollen die piezoelektrischen Dehnungskoeffizienten dij gross und - im Hinblick auf ein starkes internes Feld E(x,in) geringe relative Permittivitäten $\epsilon$ij haben. Das Verhältnis von Dehnungskoeffizienten zu elektrischen Permittivitäten liegt typischerweise im Bereich von 0.1 • $10^{-12}$ C/N (PZT) bis 2 • $10^{-12}$ C/N (PVDF). Offenbar sind PZTs wegen ihren hohen dielektrischen Konstanten trotz grossen Dehnungskoeffizienten etwas weniger attraktiv. Mit d11/$\epsilon$11 - 0.51 • $10^{-12}$ C/N liegt Quarz in einem mittleren Bereich.

Hohe Dielektrizitätskonstanten $\epsilon$ij reduzieren nicht nur die Empfindlichkeit des Sensors, die können auch bedeutende Verzerrungen des zu messenden elektrischen Feldes bewirken. Von daher hat Quarz wegen seiner verhältnismässig geringen Dielektrizitätskonstanten nicht zu unterschätzende Vorteile. Hinzu kommen ein geringer Temperatureinfluss auf Dehnungskoeffizienten und Dielektrizitätskonstanten und ein hoher elektrischer Widerstand. Dadurch wird z.B. der Einfluss von Ladungsträger-Migration, welche zu einer Frequenzabhängigkeit der Polarisation führen kann, vernachlässigbar klein. Schliesslich weist Quarz eine vorzügliche Langzeitstabilität auf.

An dieser Stelle soll nochmals darauf hingewiesen werden, dass die Richtung des internen elektrischen Feldes im piezoelektrischen Körper im allgemeinen verschieden ist von der Richtung des äusseren Feldes. Uebereinstimmung tritt nur dann auf, wenn des äussere Feld parallel sowohl zu einer (geometrischen) Körperachse als auch zu einer kristallographischen Achse liegt. Trotzdem ist der zur Scheibennormalen resp. Plattennormalen parallel liegende Anteil des internen Feldes stets proportional zum Cosinus des Winkels zwischen externem Feld und Scheibenresp. Plattennormalen bzw. Glasfaser. Dabei hängt der Proportionalitätsfaktor sowohl von der relativen Permittivität als auch von der Form des piezoelektrischen Körpers ab.

Wenn hingegen die kristallographische Vorzugsrichtung, welche parallel zur vorgegebenen Richtungskomponente liegt, nicht mit einer Körperachse zusammenfällt, dann gibt es keine einfache Beziehung zwischen Körperachse und gemessener Richtungskomponente mehr.

Es versteht sich von selbst, dass die Materialien PVDF, PZT, LiNb0$_3$ und $\alpha$-Quarz usw. auch für piezoelektrische Körper in der Form einer Platte oder eines Hohlzylinders geeignet sind. Bestimmend für die Ausführungsform ist allein die Zugehörigkeit zu einer genannten Kristallklasse.

In allen beschriebenen Ausführungsbeispielen ist die Glasfaser 5a im gegebenen Längenabschnitt (an der Platte oder an der Scheibe angeklebter Teil der Glasfaser) mit dem piezoelektrischen Körper 4 auf eine Weise verbunden, dass eine durch den inversen piezoelektrischen Effekt bewirkte Dimensionsänderung des piezoelektrischen Körpers 4 eine grösstmögliche Aenderung der Länge der Glasfaser 5a bewirkt. Dies entspricht einer bevorzugten Ausführungsform der Erfindung.

Folgende Ueberlegung soll das soeben Gesagte verdeutlichen. Liegt beispielsweise bei einer Ausführungsform gemäss Fig. 6d die Achse a1 nicht genau parallel zur Glasfaser 5a, sondern schliesst sie mit dieser einen bestimmen WInkel ein, so ist der faseroptische Sensor trotzdem richtungsempfindlich im Sinne der Erfindung. Bei einer gegebenen Feldstärke wird jedoch die Glasfaser weniger stark, eben nicht maximal, ausgedehnt, verglichen mit einer in Fig. 6d gezeigten Ausrichtung der kristallographischen Achsen.

Bei den Ausführungsformen, die anhand der Fig. 6a-e erläutert worden sind, wird der klaren Darstellung halber von einem piezoelektrischen Körper 4 in der Form einer Platte gesprochen. Dies hat seinen Grund allein darin, dass sich einer Platte ohne weiteres eine Hauptfläche und eine Plattennormale zuordnen lassen, also eine Vorzugsrichtung, wie sie die Körperachse h darstellt. Es muss aber betont werden, dass die Erfindung nicht auf plattenförmige piezoelektrischen Körper 4 beschränkt ist.

Welche Körperformen überhaupt möglich sind, lässt sich aus den nachfolgenden Ueberlegungen herleiten.

Die ideale Form ist das Ellipsoid, da dann aus elektrostatischen Gründen das Feld im Körper stets homogen ist. Bei anderen Formen treten am Rand, d.h. in der Nähe der Oberfläche, kleinere oder grössere Feldverzerrungen auf. Falls der Körper drei zueinander orthogonale geometrische Symmetrieachsen besitzt, was bei den Ausführungsformen der Tabellen I bis VI der Fall ist, dann kompensieren sich (aus Symmetriegründen) die Einflüsse der Randeffekte (Feldverzerrungen) auf das Sensorsignal gegenseitig.

Es sind aber auch Formen möglich, die keine drei orthogonalen Symmetrieachsen aufweisen (z.B. Kegelstumpf, Halbkugel). Dann müssen aber gewisse Einschränkungen bezüglich der Richtung der Glasfaser beachtet werden.

Man beachte ferner, dass in den beschriebenen, bevorzugten Ausführungsformen die vorgegebene Richtungskomponente mit einer geometrischen Symmetrieachse des Körpers zusammenfällt. Oder anders gesagt, die kristallographische Vorzugsrichtung fällt dann immer mit einer geometrischen Symmetrieachse zusammen.

Anstatt eine Phasenschiebung der Teilwelle mit einem Mach-Zehnder-Interferometer zu messen, kann irgendeine interferometrische Messmethode angewendet werden. Insbesondere entspricht es einer bevorzugten Ausführungsform, die Glasfaser 5a als faseroptisches Fabry-Perot-Interferometer auszubilden. Einzelheiten bezüglich des faseroptischen Fabry-Perot-Interferometers können der eingangs genannten Druckschrift von Yoshino et al. entnommen werden.

Für die Ausführungsformen gemäss Fig. 6a-e muss die Glasfaser nicht unbedingt auf einer geraden Linie mit dem piezoelektrischen Körper verbunden sein. Es sind auch krumme Linien zulässig.

Gemäss einer weiteren besonders bevorzugten Ausführungsform umfassen die Mittel zum Detektieren einer Aenderung der Länge der Glasfaser ein Zweimodeninterferometer. Ein solches ist z.B. im Artikel "Strain effects on highly elliptical core taro-mode fibers", J.N. Blake et al, Optics Letters Vol. 12 No. 9 (1987), s. 732 ff oder "Use of higliy elliptical core fibbers for two-mode fiber devices", B.Y. Kim et al, Optics Letters Vo. 12 No. 9 (1987), S. 729 ff. Zwar weist dieses Zweimodeninterferometer eine bedeutend geringere Empfindlichkeit bezüglich der Längenänderung der Glasfaser auf als ein Mach-Zehnder-Interferometer, lässt sich aber sehr einfach und kostengünstig realisieren.

Aehnliche Vorteile wie das Zweimodeninterferometer weist ein ebenfalls bevorzugtes Polarisationsinterferometer nach W. Eickhoff, Optics Lett. 6, 204, 1981, auf. Dabei werden zwei orthogonal zueinander polarisierte Moden, welche bei der Längenänderung der Glasfaser unterschiedliche Phasenverschiebungen erfahren, zur Interferenz gebracht.

Abschliessend kann gesagt werden, dass die Erfindung einen faseroptischen Sensor zum Messen einer bestimmten Richtungskomponente eines elektrischen Feldes schafft, welcher empfindlich ist, und einfach herzustellen ist.

**Patentansprüche**

1. Faseroptischer Sensor zum Messen einer vorbestimmten Richtungskomponente eines elektrischen Feldes, umfassend
   a) einen piezoelektrischen Körper (4), der die Form einer Scheibe aufweist;
   b) eine Glasfaser (5a), welche in einem gegebenen Längenabschnitt mit dem piezoelektrischen Körper (4) starr verbunden ist;
   c) Mittel zum Detektieren einer Ausdehnung der Länge der Glasfaser (5a), wobei diese Mittel ein Zweimodeninterferometer oder ein Polarisationsinterferometer umfassen, wobei
   d) die Glasfaser spiralförmig um eine Scheibennormale, gegeben durch eine Normale auf die planen Scheibenflächen, gewickelt ist;
   dadurch gekennzeichnet, dass
   e) der piezoelektrische Körper (4) ein Kristall ist, welcher einer der Kristallklassen C2, C2v, C4v, C4, C3, C3v, C6, C6v, D3, D3h angehört;
   f) eine kristallographische Orientierung des piezoelektrischen Körpers (4), gegeben durch eine zur Scheibennormalen parallel liegende kristallographischen Drehachse, gemäss folgender Tabelle gewählt wird:

| Kristallklasse (Schoenflies [international]) | Drehachse parallel zur Scheibennormalen |
|---|---|
| C2 [2] | 2-zählige Achse |
| C2v [2mm] | 2-zählige Achse |
| C3 [3] | 3-zählige Achse |
| C3v [3m] | 3-zählige Achse |
| D3 [32] | 2-zählige Achse |
| D3h [62m] | 2-zählige Achse |
| C4 [4] | 4-zählige Achse |
| C6 [6] | 6-zählige Achse |
| C4v [4mm] | 4-zählige Achse |
| C6v [6mm] | 6-zählige Achse |

   g) die vorbestimmte Richtungskomponente mit der Scheibennormalen zusammenfällt; und
   h) ein senkrecht zur vorbestimmten Richtungskomponente liegender Anteil des elektrischen Feldes keine Änderung der Länge der Glasfaser bewirkt.

**2.** Faseroptischer Sensor nach Anspruch 1, dadurch gekennzeichnet, dass die Glasfaser (5a) mindestens einmal um den Rand des scheibenförmigen, piezoelektrischen Körpers (4) gewickelt ist.

**3.** Faseroptischer Sensor zum Messen einer vorbestimmten Richtungskomponente eines elektrischen Feldes, umfassend

a) einen piezoelektrischen Körper (4), der die Form einer Platte aufweist;

b) eine Glasfaser (5a), welche in einem gegebenen Längenabschnitt mit dem piezoelektrischen Körper (4) starr verbunden ist; und

c) Mittel zum Detektieren einer Ausdehnung der Länge der Glasfaser (5a), wobei diese Mittel ein Zweimodeninterferometer oder ein Polarisationsinterferometer umfassen;

dadurch gekennzeichnet, dass

d) die Glasfaser (5a) mit dem gegebenen Längenabschnitt parallel zur vorbestimmten Richtungskomponente liegt;

e) der piezoelektrische Körper (4) ein Kristall ist, welcher einer der Kristallklassen C2, C2v, C3, C3v, C4, C4v, C6, C6v, D3, D3h, T, Td angehört;

f) eine kristallographische Orientierung des piezoelektrischen Körpers (4), gegeben durch eine zur Glasfaser (5a) parallel liegende kristallographische Drehachse, gemäss folgender Tabelle gewählt wird:

| Kristallklasse (Schoenflies [international]) | Drehachse parallel zur Glasfaser |
|---|---|
| C2 [2] | 2-zählige Achse |
| C2v [2mm] | 2-zählige Achse |
| C3 [3] | 3-zählige Achse |
| C3v [3m] | 3-zählige Achse |
| D3 [32] | 2-zählige Achse |
| D3h [62m] | 2-zählige Achse |
| C4 [4] | 4-zählige Achse |
| C6 [6] | 6-zählige Achse |
| C4v [4mm] | 4-zählige Achse |
| C6v [6mm] | 6-zählige Achse |
| T [23] | 3-zählige Achse |
| Td [43m] | 3-zählige Achse |

und

g) ein senkrecht zur vorbestimmten Richtungskomponente liegender Anteil des elektrischen Feldes keine Änderung der Länge der Glasfaser bewirkt.

**4.** Faseroptischer Sensor zum Messen einer vorbestimmten Richtungskomponente eines elektrischen Feldes, umfassend

a) einen piezoelektrischen Körper (4), der die Form einer Platte aufweist;

b) eine Glasfaser (5a), welche in einem gegebenen Längenabschnitt mit dem piezoelektrischen Körper (4) starr verbunden ist; und

c) Mittel zum Detektieren einer Ausdehnung der Länge der Glasfaser (5a), wobei diese Mittel ein Zweimodeninterferometer oder ein Polarisationsinterferometer umfassen;

wobei

d) die Glasfaser (5a) mit dem gegebenen Längenabschnitt senkrecht zur vorbestimmten Richtungskomponente liegt;

dadurch gekennzeichnet, dass

e) der piezoelektrische Körper (4) ein Kristall ist, welcher einer der Kristallklassen C2, C2v, C4, C4v, C6, C6v, D2, D2d, D3, D3h, D4, D6, S4, T, Td angehört;

f) eine kristallographische Orientierung des piezoelektrischen Körpers (4), gegeben durch eine zur vorbestimmten Richtungskomponente parallel bzw. senkrecht liegende kristallographische Drehachse, gemäss den folgenden Tabellen gewählt wird:

| Kristallklasse (Schoenflies [international]) | | Drehachse $\parallel$ bzw. $\perp$ zur vorbestimmten Richtungskomponente. | Richtung der Glasfaser für max. Dehnung |
|---|---|---|---|
| C2 | [2] | $\parallel$ 2-zählige Achse | abhängig vom Verhältnis der Dehnungskoeffizienten |
| C2v | [2mm] | $\parallel$ 2-zählige Achse | |
| S4 | [$\bar{4}$] | $\parallel$ $\bar{4}$-zählige Achse | |
| C4 | [4] | $\parallel$ 4-zählige Achse | beliebig |
| C6 | [6] | $\parallel$ 6-zählige Achse | |
| C4v | [4mm] | $\parallel$ 4-zählige Achse | |
| C6v | [6mm] | $\parallel$ 6-zählige Achse | |
| D3 | [32] | $\parallel$ 2-zählige Achse | abhängig von d14/d11 |
| D3h | [$\bar{6}$2m] | $\parallel$ 2-zählige Achse | $\perp$ 3-zählige Achse |
| D2 | [222] | $\parallel$ 2-zählige Achse | 45° bezüglich 2-zähliger Achse |
| D2d | [$\bar{4}$2m] | $\parallel$ 2-zählige Achse | |
| T | [23] | $\parallel$ 2-zählige Achse | 45° bezüglich 2-zähliger Achse |
| Td | [$\bar{4}$3m] | $\parallel$ $\bar{4}$-zählige Achse | 45° bezüglich $\bar{4}$-zähliger Achse |
| D4 | [422] | $\perp$ 4-zählige Achse | 45° bezüglich 4-zähliger Achse |
| D6 | [622] | $\perp$ 6-zählige Achse | 45° bezüglich 6-zähliger Achse |

EP 0 316 619 B1

| Kristallklasse (Schoenflies [international]) | | Drehachse ∥ bzw. ⊥ zur vorbestimmten Richtungskomponente | unzulässige Orientierung der Glasfaser |
|---|---|---|---|
| C2 | [2] | ∥ 2-zählige Achse | $d23\cos^2\alpha + d21\sin^2\alpha + d25\sin 2\alpha = 0$ *) |
| C2v | [2mm] | ∥ 2-zählige Achse | $\tan\alpha = \sqrt{-d32/d31}$ **) |
| S4 | [$\overline{4}$] | ⊥ und ∥ $\overline{4}$-zählige Achse | $\tan 2\alpha = -d31/d36$ **) |
| C4 | [4] | ∥ 4-zählige Achse | |
| C6 | [6] | ∥ 6-zählige Achse | |
| C4v | [4mm] | ∥ 4-zählige Achse | |
| C6v | [6mm] | ∥ 6-zählige Achse | |
| D3 | [32] | ∥ 2-zählige Achse | ∥ 3-zählige Achse ***) und $\tan\alpha = 2d14/d11$ |
| D3h | [$\overline{6}$2m] | ∥ 2-zählige Achse | ∥ 3-zählige Achse |
| D2 | [222] | ∥ 2-zählige Achse | ∥ 2-zählige Achse |
| D2d | [$\overline{4}$2m] | ∥ 2-zählige Achse | ∥ 2-zählige Achse |
| T | [23] | ∥ 2-zählige Achse | ∥ 2-zählige Achse |
| Td | [$\overline{4}$3m] | ∥ $\overline{4}$-zählige Achse | ∥ $\overline{4}$-zählige Achse |
| D4 | [422] | ⊥ 4-zählige Achse | ∥ und ⊥ 4-zählige Achse |
| D6 | [622] | ⊥ 6-zählige Achse | ∥ und ⊥ 6-zählige Achse |

```
*)      α = Winkel zwischen z-Achse und Glasfaser
**)     α = Winkel zwischen x-Achse und Glasfaser
***)    α = Winkel zwischen 3-zähliger Achse und Glasfaser
dij     = piezoelektrische Dehnungskoeffizienten
```

Der Winkel α ist positiv, wenn die Achse gegenüber der Glasfaser im Gegenuhrzeigersinn gedreht wird.

und

g) ein senkrecht zur vorbestimmten Richtungskomponente liegender Anteil des elektrischen Feldes keine Änderung der Länge der Glasfaser bewirkt.

5. Faseroptischer Sensor nach Anspruch 3 oder 4, dadurch gekennzeichnet, dass die Glasfaser (5a) in einer Nut auf einer der Plattenoberflächen befestigt ist.

6. Faseroptischer Sensor nach Anspruch 4, dadurch gekennzeichnet, dass eine Plattennormale parallel zur vorbestimmtem Richtungskomponente liegt.

7. Faseroptischer Sensor nach Anspruch 4, dadurch gekennzeichnet, dass eine Plattennormale senkrecht zur vorbestimmtem Richtungskomponente liegt.

8. Faseroptischer Sensor nach Anspruch 6 oder 7, dadurch gekennzeichnet, dass die Richtung des gegebenen Längenabschnitts der Glasfaser (5a) in Bezug auf die kristallographische Orientierung so gewählt wird, dass eine Dimensionsänderung des piezoelektrischen Körpers (4) die grösstmögliche Änderung der Länge der Glasfaser bewirkt.

**Claims**

1. Fibre-optic sensor for measuring a predetermined directional component of an electric field, comprising

a) a piezoelectric body (4) which has the shape of a disk;

b) a glass fibre (5a) which is rigidly connected to the piezoelectric body (4) in a given length section;

c) means for detecting an expansion in the length of the glass fibre (5a), these means comprising a two-mode interferometer or a polarization interferometer it being the case that,

d) the glass fibre being wound spirally around a disk normal given by a normal to the planar disk surfaces;

characterized in that

e) the piezoelectric body (4) is a crystal which belongs to one of the crystal classes C2, C2v, C4v, C4, C3, C3v, C6, C6v, D3, D3h;

f) a crystallographic orientation of the piezoelectric body (4), given by a crystallographic axis of rotation which is parallel to the disk normal, in accordance with the following table:

| Crystal class (Schoenflies [international]) | Axis of rotation parallel to the disk normal |
|---|---|
| C2 [2] | 2-fold axis |
| C2v [2mm] | 2-fold axis |
| C3 [3] | 3-fold axis |
| C3v [3m] | 3-fold axis |
| D3 [32] | 2-fold axis |
| D3h [62m] | 2-fold axis |
| C4 [4] | 4-fold axis |
| C6 [6] | 6-fold axis |
| C4v [4mm] | 4-fold axis |
| C6v [6mm] | 6-fold axis |

g) the predetermined directional component coincides with the disk normal; and

h) a component of the electric field which is perpendicular to the predetermined directional component does not cause any change in the length of the glass fibre.

2. Fibre-optic sensor according to Claim 1, characterized in that the glass fibre (5a) is wound at least once around the edge of the disk-shaped, piezoelectric body (4).

3. Fibre-optic sensor for measuring a predetermined directional component of an electric field, comprising

a) a piezoelectric body (4) which has the shape of a plate;

b) a glass fibre (5a) which is rigidly connected to the piezoelectric body (4) in a given length section; and

c) means for detecting an expansion in the length of the glass fibre (5a), these means comprising a two-mode interferometer or a polarization interferometer;

characterized in that

d) the glass fibre (5a) having the given length section is parallel to the predetermined directional component;

e) the piezoelectric body (4) is a crystal which belongs to one of the crystal classes C2, C2v, C3, C3v, C4, C4v, C6, C6v, D3, D3h, T, Td;

f) a crystallographic orientation of the piezoelectric body (4), given by a crystallographic axis of rotation which is parallel to the disk normal, in accordance with the following table:

| Crystal class (Schoenflies [international]) | Axis of rotation parallel to the disk normal |
|---|---|
| C2 [2] | 2-fold axis |
| C2v [2mm] | 2-fold axis |
| C3 [3] | 3-fold axis |
| C3v [3m] | 3-fold axis |
| D3 [32] | 2-fold axis |
| D3h [62m] | 2-fold axis |
| C4 [4] | 4-fold axis |
| C6 [6] | 6-fold axis |
| C4v [4mm] | 4-fold axis |
| C6v [6mm] | 6-fold axis |
| T [23m] | 3-fold axis |
| Td [43m] | 3-fold axis |

and

g) a component of the electric field which is perpendicular to the predetermined directional component does not cause any change in the length of the glass fibre.

4. Fibre-optic sensor for measuring a predetermined directional component of an electric field, comprising
   a) a piezoelectric body (4) which has the shape of a plate;
   b) a glass fibre (5a) which is rigidly connected to the piezoelectric body (4) in a given length section; and
   c) means for detecting an expansion in the length of the glass fibre (5a), these means comprising a two-mode interferometer or a polarization interferometer,
   d) the glass fibre (5a) having the given length section being perpendicular to the predetermined directional component;
characterized in that
   e) the piezoelectric body (4) is a crystal which belongs to one of the crystal classes C2, C2v, C4, C4v, C6, C6v, D2, D2d, D3, D3h, D4, D6, S4, T, Td;
   f) a crystallographic orientation of the piezoelectric body (4), given by a crystallographic axis of rotation which is parallel or perpendicular to the predetermined directional component, is selected in accordance with the following tables:

| Crystal class (Schoenflies [international]) | Axis of rotation ∥ or ⊥ to the predetermined directional component | Direction of the glass fibre for maximum expansion |
|---|---|---|
| C2   [2] | ∥ 2-fold axis | Depending on the ratio |
| C2ν  [2 mm] | ∥ 2-fold axis | of the coefficients |
| S4   [4̄] | ∥ 4̄-fold axis | of expansion |
| C4   [4] | ∥ 4-fold axis | |
| C6   [6] | ∥ 6-fold axis | arbitrary |
| C4ν  [4 mm] | ∥ 4-fold axis | |
| C6ν  [6 mm] | ∥ 6-fold axis | |
| D3   [32] | ∥ 2-fold axis | depending on d14/d11 |
| D3h  [6̄2 m] | ∥ 2-fold axis | ⊥ 3-fold axis |
| D2   [222] | ∥ 2-fold axis | 45° with resp. |
| D2d  [4̄2 m] | ∥ 2-fold axis | to 2-fold axis |
| T    [23] | ∥ 2-fold axis | 45° with resp. to 2-fold axis |
| Td   [4̄3 m] | ∥ 4̄-fold axis | 45° with resp. to 4̄-fold axis |
| D4   [422] | ⊥ 4-fold axis | 45° with resp. to 4-fold axis |
| D6   [622] | ⊥ 6-fold axis | 45° with resp. to 6-fold axis |

| Crystal class (Schoenflies [international]) | | Axis of rotation ∥ or ⊥ to the predetermined directional component | Inadmissible orientation of the glass fibre |
|---|---|---|---|
| C2 | [2] | ∥ 2-fold axis | $d23\ \cos^2\alpha + \sigma21\ \sin^2\alpha + \sigma25\ \sin2\alpha = 0$ *) |
| C2ν | [2 mm] | ∥ 2-fold axis | $\tan\alpha = \sqrt{-d32/d31}$ **) |
| S4 | [4̄] | ⊥ and ∥ 4̄-fold axis | $\tan2\alpha = -d31/d36$ **) |
| C4 | [4] | ∥ 4-fold axis | |
| C6 | [6] | ∥ 6-fold axis | |
| C4ν | [4 mm] | ∥ 4-fold axis | |
| C6ν | [6 mm] | ∥ 6-fold axis | |
| D3 | [32] | ∥ 2-fold axis | ∥ 3-fold axis ***) and $\tan\alpha = 2d14/d11$ |
| D3h | [6̄2 m] | ∥ 2-fold axis | ∥ 3-fold axis |
| D2 | [222] | ∥ 2-fold axis | ∥ 2-fold axis |
| D2d | [4̄2 m] | ∥ 2-fold axis | ∥ 2-fold axis |
| T | [23] | ∥ 2-fold axis | ∥ 2-fold axis |
| Td | [4̄3 m] | ∥ 4̄-fold axis | ∥ 4̄-fold axis |
| D4 | [422] | ⊥ 4-fold axis | ∥ and ⊥ 4-fold axis |
| D6 | [622] | ⊥ 6-fold axis | ∥ and ⊥ 6-fold axis |

*)   $\alpha$ = Angle between Z-axis and glass fibre

**)   $\alpha$ = Angle between X-axis and glass fibre

***)   $\alpha$ = Angle between 3-fold axis and glass fibre

dij   = Piezoelectric coefficient of expansion

The angle $\alpha$ is positive if the axis is rotated in the counter-clockwise direction compared with the glass fibre.

and

g) a component of the electric field which is perpendicular to the predetermined directional component does not cause any change in the length of the glass fibre.

5. Fibre-optic sensor according to Claim 3 or 4, characterized in that the glass fibre (5a) is attached in a groove on one of the plate surfaces.

6. Fibre-optic sensor according to Claim 4, characterized in that a plate normal is parallel to the predetermined directional component.

7. Fibre-optic sensor according to Claim 4, characterized in that a plate normal is perpendicular to the predetermined directional component.

EP 0 316 619 B1

**8.** Fibre-optic sensor according to Claim 6 or 7, characterized in that the direction of the given length section of the glass fibre (5a) with respect to the crystallographic orientation is selected in such a manner that a change in the dimensions of the piezoelectric body (4) causes the greatest possible change in the length of the glass fibre.

**Revendications**

**1.** Senseur à fibre optique pour la mesure d'une composante de direction prédéterminée d'un champ électrique, comprenant :

a) un corps piézoélectrique (4), de la forme d'un disque;

b) une fibre de verre (5a), qui est fixée de manière rigide par un fragment de longueur donnée au corps piézoélectrique (4);

c) des moyens de détection d'une extension de la longueur de la fibre de verre (5a), ces moyens comprenant un interféromètre à deux modes ou un interféromètre à polarisation, où

d) la fibre de verre est enroulée en hélice autour d'une normale au disque, donnée par une normale aux surfaces planes de la surface du disque;

caractérisé en ce que :

e) le corps piézoélectrique (4) est un cristal, qui appartient à une des classes cristallines C2, C2v, C4v, C4, C3, C3v, C6, C6v, D3, D3h;

f) une orientation cristallographique du corps piézoélectrique (4), donnée par un axe de rotation cristallographique parallèle à la normale au disque, est choisie conformément au tableau suivant :

| Classe cristalline [Schönflies (international)] | Axe de rotation parallèle à une normale au disque |
|---|---|
| C2 [2] | axe d'ordre 2 |
| C2v [2mm] | axe d'ordre 2 |
| C3 [3] | axe d'ordre 3 |
| C3v [3m] | axe d'ordre 3 |
| D3 [32] | axe d'ordre 2 |
| D3h [62m] | axe d'ordre 2 |
| C4 [4] | axe d'ordre 4 |
| C6 [6] | axe d'ordre 6 |
| C4v [4mm] | axe d'ordre 4 |
| C6v [6mm] | axe d'ordre 6 |

g) la composante de direction prédéterminée coïncide avec la normale au disque, et

h) une fonction du champ électrique perpendiculaire à la composante de direction prédéterminée ne provoque aucune modification de la longueur de la fibre de verre.

**2.** Senseur à fibre optique suivant la revendication 1, caractérisé en ce que la fibre de verre (5a) est enroulée au moins une fois autour du bord du corps piézoélectrique (4) en forme de disque.

**3.** Senseur à fibre optique pour la mesure d'une composante de direction prédéterminée d'un champ électrique, comprenant :

a) un corps piézoélectrique (4), de la forme d'une plaque;

b) une fibre de verre (5a), qui est fixée de manière rigide, par un fragment de longueur donnée, au corps piézoélectrique (4);

c) des moyens de détection d'une extension de la longueur de la fibre de verre (5a), ces moyens comprenant un interféromètre à deux modes ou un interféromètre à polarisation;

caractérisé en ce que :

d) la fibre de verre (5a) par le fragment de longueur donnée, est parallèle à la composante de direction prédéterminée;

20

e) le corps piézoélectrique (4) est un cristal, qui appartient à une des classes cristallines C2, C2v, C3, C3v, C4, C4v, C6, C6v, D3, D3h, T, Td;

f) une orientation cristallographique du corps piézoélectrique (4), donnée par un axe de rotation cristallographique parallèle à la fibre de verre (5a), est choisie conformément au tableau suivant :

| Classe cristalline [Schönflies (international)] | Axe de rotation parallèle à une normale au disque |
|---|---|
| C2 [2] | axe d'ordre 2 |
| C2v [2mm] | axe d'ordre 2 |
| C3 [3] | axe d'ordre 3 |
| C3v [3m] | axe d'ordre 3 |
| D3 [32] | axe d'ordre 2 |
| D3h [62m] | axe d'ordre 2 |
| C4 [4] | axe d'ordre 4 |
| C6 [6] | axe d'ordre 6 |
| C4v [4mm] | axe d'ordre 4 |
| C6v [6mm] | axe d'ordre 6 |
| T [23] | axe d'ordre 3 |
| Td [43m] | axe d'ordre 3 |

et

g) une fraction du champ électrique perpendiculaire à la composante de direction prédéterminée ne provoque aucune modification de la longueur de la fibre de verre.

4. Senseur à fibre optique pour la mesure d'une composante de direction prédéterminée d'un champ électrique, comprenant :

a) un corps piézoélectrique (4), de la forme d'une plaque;

b) une fibre de verre (5a), qui est fixée de manière rigide par un fragment de longueur donnée au corps piézoélectrique (4);

c) des moyens de détection d'une extension de la longueur de la fibre de verre (5a), ces moyens comprenant un interféromètre à deux modes ou un interféromètre à polarisation, où

d) la fibre de verre (5a) par le fragment de longueur donnée, est perpendiculaire à la composante de direction prédéterminée;

caractérisé en ce que

e) le corps piézoélectrique (4) est un cristal, qui appartient à une des classes cristallines C2, C2v, C4, C4v, C6, C6v, D2, D2d, D3, D3h, D4, D6, S4, T, Td;

f) une orientation cristallographique du corps piézoélectrique (4), donnée par un axe de rotation cristallographique parallèle ou perpendiculaire à la composante de direction prédéterminée, est choisie conformément au tableau suivant :

EP 0 316 619 B1

| Classe cristalline [(Schönflies international)] | Axe de rotation // ou ⊥ à la composante de direction prédéterminée | Direction de la fibre de verre pour une dilatation maximale |
|---|---|---|
| C2 [2] | axe d'ordre 2 // | dépend de la proportion des coefficients de dilatation |
| C2v [2mm] | axe d'ordre 2 // | |
| S4 [$\overline{4}$] | axe d'ordre $\overline{4}$ // | |
| C4 [4] | axe d'ordre 4 // | quelconque |
| C6 [6] | axe d'ordre 6 // | |
| C4v [4mm] | axe d'ordre 4 // | |
| C6v [6mm] | axe d'ordre 6 // | |
| D3 [32] | axe d'ordre 2 // | dépend de d14/d11 |
| D3h [$\overline{6}$2m] | axe d'ordre 2 // | ⊥ à l'axe d'ordre 3 |
| D2 [222] | axe d'ordre 2 // | 45° de l'axe d'ordre 2 |
| D2d [$\overline{4}$2m] | axe d'ordre 2 // | |

| Classe cristalline [(Schönflies interna-tional)] | Axe de rotation // ou ⊥ à la composante de direction prédéterminée | Direction de la fibre de verre pour une dilatation maximale |
|---|---|---|
| T [23] | axe d'ordre 2 // | 45° de l'axe d'ordre 2 |
| Td [$\overline{4}$3] | axe d'ordre $\overline{4}$ // | 45° de l'axe d'ordre 4 |
| D4 [422] | axe d'ordre 4 ⊥ | 45° de l'axe d'ordre 4 |
| D6 [622] | axe d'ordre 6 ⊥ | 45° de l'axe d'ordre 6 |

| Classe cristalline [Schönflies (international)] | Axe de rotation // ou ⊥ à la composante de direction prédéterminée | Orientation inadmissible de la fibre de verre |
|---|---|---|
| C2 [2] | axe d'ordre 2 // | $d23 \cos^2\alpha + d21 \sin^2\alpha + d25 \sin2\alpha = 0$ (*) |
| C2v [2mm] | axe d'ordre 2 // | $tg\alpha = \sqrt{-d3\overline{2}/d3\overline{1}}$ (**) |
| S4 [$\overline{4}$] | axe d'ordre $\overline{4}$ // et ⊥ | $tg2\alpha = -d31/d36$ (**) |
| C4 [4] | axe d'ordre 4 // | |
| C6 [6] | axe d'ordre 6 // | |
| C4v [4mm] | axe d'ordre 4 // | |
| C6v [6mm] | axe d'ordre 6 // | |
| D3 [32] | axe d'ordre 2 // | // à l'axe d'ordre 3 (***) et $tg\ \alpha = 2d14/d11$ |
| D3h [$\overline{6}$2m] | axe d'ordre 2 // | // à l'axe d'ordre 3 |
| D2 [222] | axe d'ordre 2 // | // à l'axe d'ordre 2 |

| Classe cristalline [Schönflies (international)] | Axe de rotation // ou ⊥ à la composante de direction prédéterminée | Orientation inadmissible de la fibre de verre |
|---|---|---|
| · D2d [$\overline{4}$2m] | axe d'ordre 2 // | // à l'axe d'ordre 2 |
| T [23] | axe d'ordre 2 // | // à l'axe d'ordre 2 |
| Td [$\overline{4}$3m] | axe d'ordre $\overline{4}$ // | // à l'axe d'ordre 4 |
| D4 [422] | axe d'ordre 4 ⊥ | // et ⊥ à l'axe d'ordre 4 |
| D6 [622] | axe d'ordre 6 ⊥ | // et ⊥ à l'axe d'ordre 6 |

(*) α = angle entre l'axe z et la fibre de verre,
(**) α = angle entre l'axe x et la fibre de verre,
(***) α = angle entre l'axe d'ordre 3 et la fibre de verre,
dij = coefficient de dilatation piézoélectrique.

L'angle α est positif, quand l'axe est tourné dans le sens inverse des aiguilles d'une montre par rapport à la fibre de verre.

g) une fraction du champ électrique perpendiculaire à la composante de direction prédéterminée ne provoque aucune modification de la longueur de la fibre de verre.

et

5. Senseur à fibre optique suivant la revendication 3 ou 4, caractérisé en ce que la fibre de verre (5a) est fixée à une surface de la plaque dans une rainure.

6. Senseur à fibre optique suivant la revendication 4, caractérisé en ce qu'une normale à la plaque est parallèle à la composante de direction prédéterminée.

7. Senseur à fibre optique suivant la revendication 4, caractérisé en ce qu'une normale à la plaque est perpendiculaire à la composante de direction prédéterminée.

8. Senseur à fibre optique suivant la revendication 6 ou 7, caractérisé en ce que la direction du fragment de longueur donnée de la fibre de verre (5a) est choisie par rapport à l'orientation cristallographique, de sorte qu'une modification des dimensions du corps piézoélectrique (4) produise une modification la plus grande possible de la longueur de la fibre de verre.

FIG.1

FIG.2

FIG.4

FIG.3

FIG.5

EP 0 316 619 B1

FIG.6a

FIG.6b

FIG.6c

FIG.6e

FIG.6d

Fig. 7

28